# EUROPÄISCHE PATENTSCHRIFT

(11) **EP 1 855 297 B1**
(45) Veröffentlichungstag und Bekanntmachung des Hinweises auf die Patenterteilung: **13.07.2016**
(21) Anmeldenummer: 06009474.5
(22) Anmeldetag: 08.05.2006
(51) Int. Cl.: H01F 17/00, H01F 19/08, H01L 27/08

(54) **Signalübertrager und Signalübertragungsvorrichtung mit einem Signalübertrager**
Signal transformer and signal transmitting device with a signal transformer
Transformateur de signaux et appareil transmetteur de signaux avec un transformateur de signaux

(43) Veröffentlichungstag der Anmeldung: 14.11.2007
(73) Patentinhaber: Infineon Technologies Austria AG, 9500 Villach (AT)
(72) Erfinder: Feldtkeller, Martin, 81543 München (DE)
(74) Vertreter: Westphal, Mussgnug & Partner Patentanwälte mbB

(56) Entgegenhaltungen:
- DE-A1- 10 232 642
- DE-A1-102004 036 139
- US-A1- 2003 222 750
- US-A1- 2004 070 481

## Beschreibung

Die vorliegende Erfindung betrifft einen Signalübertrager mit einer Primärwicklung und einer induktiv mit der Primärwicklung gekoppelten Sekundärwicklung und eine Signalübertragungsvorrichtung mit einem solchen Signalüberträger.

Die Primärwicklung und die Sekundärwicklung eines solchen Signalübertragers bilden einen Transformator, der eine Signalübertragung zwischen zwei galvanisch entkoppelten Schallkreisen ermöglicht.

Die Erfindung betrifft insbesondere Signalübertrager, die zur galvanisch entkoppelten Signalübertragung auf einem Siliziumchip mit den in der Halbleitertechnik üblichen Verfahren hergestellt werden können. Diese Signalübertrager werden üblicherweise durch mehrere übereinander liegende Planarspulen realisiert und haben keinen die induktive Kopplung zwischen Primär- und Sekundärwicklung verstärkenden ferromagnetischen Kern, weshalb sie auch als "Coreless Transformer" bezeichnet werden. Solche Coreless Transformer sind beispielsweise in der DE 101 00 282 A1 (Strzalkowski et al.) oder der DE 102 32 642 (Strzalkowski et al.) beschrieben.

Die DE 10 2004 036 139 A1 (Strzalkowski, Feldtkeller) offenbart den Oberbegriff des Anspruchs 1 und beschreibt eine Bauelementanordnung mit einem planaren Transformator, dessen Sekundärwicklung in zwei übereinander angeordneten Metallisierungsebenen realisiert ist.

Die DE 10 2004 039 218 A1 (Feldtkeller) beschreibt ein Datenübertragungsverfahren über eine Datenübertragungsvorrichtung mit zwei Transformatoren, bei dem zur Datenübertragung jeweils gegenphasige steile Flanken an Primärwicklungen der Transformatoren angelegt werden.

Zwischen der Primärwicklung und der Sekundärwicklung eines Signalübertragers ist unvermeidlich eine parasitäre kapazitive Kopplung vorhanden. Tritt bei einem solchen Übertrager während des Betriebs eine rasche Änderung einer zwischen Primärwicklung und Sekundärwicklung anliegenden Spannung auf - beispielsweise indem eine sekundärseitiges Bezugspotential rasch gegenüber einem primärseitigen Bezugspotential ansteigt - so kann es zwischen Primärseite und Sekundärseite zu kapazitiven Verschiebeströmen kommen, die in unvermeidlich vorhandenen Leitungswiderständen der Primär- und Sekundärwicklung und in Streuinduktivitäten Spannungen induzieren, die sich den zu übertragenden Nutzsignalen überlagern.

Die US 2003/0222750 A1 beschreibt eine Spulenanordnung mit zwei Spulen, die in unterschiedlichen Metallisierungsebenen eines Halbleiterchips angeordnet sind und bei der jede der Spulen einen Wicklungsabschnitt in jeder der Metallisierungsebenen aufweist.

Aufgabe der vorliegenden Erfindung ist es, einen Signalübertrager mit einer Primärwicklung und einer Sekundärwicklung zur Verfügung zu stellen, der robust gegen rasche Spannungsänderungen zwischen der Primärwicklung und der Sekundärwicklung ist und der darüber hinaus platzsparend realisierbar ist, und eine Signalübertragungsvorrichtung mit einem solchen Signalübertrager zur Verfügung zu stellen.

Diese Aufgabe wird durch einen Signalübertrager nach Anspruch 1 und durch eine Signalübertragungsvorrichtung nach Anspruch 20 gelöst.

Der Signalübertrager umfasst eine Primärwicklung und eine erste und wenigstens eine zweite Sekundärwicklung, die in einer ersten Richtung beabstandet zu der Primärwicklung angeordnet sind, die jeweils induktiv mit der Primärwicklung gekoppelt sind und die jeweils wenigstens zwei in Reihe geschaltete Wicklungsabschnitte aufweist. Die wenigstens zwei Wicklungsabschnitte jeder der ersten und zweiten Sekundärwicklungen sind dabei in wenigstens zwei unterschiedlichen Wicklungsebenen angeordnet und die Wicklungsabschnitte wenigstens einer Wicklungsebene weisen an jeweils einem Ende eine zahnförmige Struktur mit Verbindungsanschlüssen auf.

Bei diesem Signalübertrager sind zwei Sekundärwicklungen in platzsparender Weise in nur zwei Wicklungsebene realisiert, die darüber hinaus so realisiert werden können, dass sie derart symmetrisch zueinander angeordnet sind, dass sie in bleicher Weise kapazitiv und induktiv mit der Primärwicklung gekoppelt sind. Während des Betriebs des Signalübertragers werden bei einer Anregung der Primärwicklung in den beiden Sekundärwicklungen aufgrund der gleichen Kopplung der beiden Sekundärwicklungen an die Primärwicklung gleiche Spannungen induziert.

Um eine symmetrische Anordnung der beiden Sekundärwicklungen zu erhalten, können die wenigstens zwei Wicklungsabschnitte einer Sekundärwicklung in einer zweiten Richtung, die sankrecht zu der ersten Richtung verläuft, versetzt zueinander in den wenigstens zwei Wicklungsebenen angeordnet sind.

Bei einer Ausführungsform des Signalübertragers ist vorgesehen, dass ein erster Stapel von Wicklungsabschnitten vorhanden ist, der in der ersten Richtung ausgehend von der Primärwicklung abwechselnd Wicklungsabschnitte der ersten und zweiten Sekundärwicklung aufweist, und dass ein zweiter Stapel von Wicklungsabschnitten vorhanden ist, der in der ersten Richtung ausgehend von der Primärwicklung abwechselnd Wicklungsabschnitte der zweiten und ersten Sekundärwicklung aufweist. Der erste Stapel ist hierbei in der zweiten Richtung benachbart zu dem ersten Stapel angeordnet.

Außerdem können die beiden Sekundärwicklungen an einem gemeinsamen Bezugspotentialanschluss angeschlossen sein.

Die vorliegende Erfindung wird nachfolgend anhand von Figuren näher erläutert.
- Figur 1: zeigt ein erstes Ausführungsbeispiel eines erfindungsgemäßen Signalübertragers, der eine Primärwicklung und eine Sekundärwicklung aufweist, in verschiedenen Schnittdarstellungen.
- Figur 2: zeigt das elektrische Ersatzschaltbild des Signalübertragers gemäß Figur 1.
- Figur 3: erläutert ein mögliches Signalübertragungsverfahren über den Signalübertrager.
- Figur 4: zeigt eine Datenübertragungsvorrichtung mit einem erfindungsgemäßen Signalübertrager.
- Figur 5: zeigt ein weiteres Ausführungsbeispiel eines erfindungsgemäßen Signalübertragers.
- Figur 6: zeigt ein Ausführungsbeispiel eines Signalübertragers, bei dem drei Sekundärwicklungen in drei Wicklungsebenen angeordnet sind.
- Figur 7: zeigt ein weiteres Ausführungsbeispiel eines erfindungsgemäßen Signalübertragers.
- Figur 8: zeigt ein weiteres Ausführungsbeispiel eines erfindungsgemäßen Signalübertragers.

In den Figuren bezeichnen, sofern nicht anders angegeben, gleiche Bezugszeichen gleiche Bauelemente und Signale mit gleicher Bedeutung.

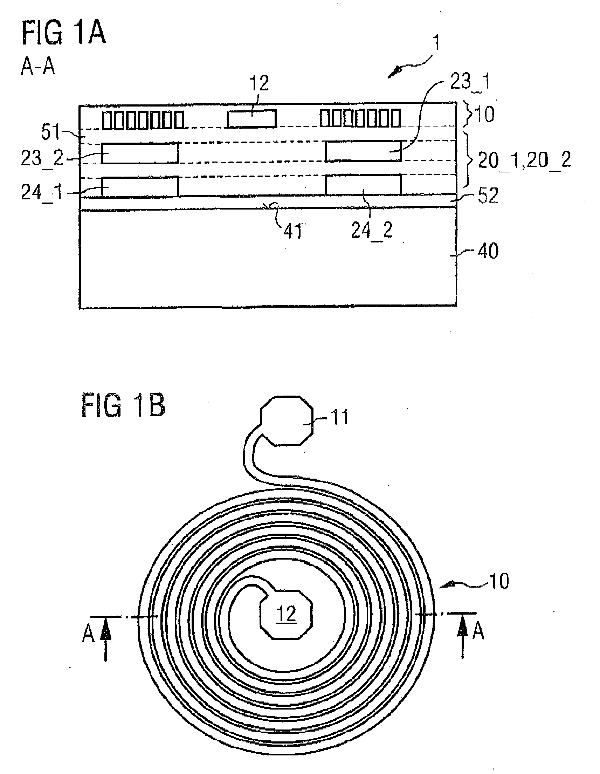

Ein Ausführungsbeispiel eines erfindungsgemäßen Signalübertragers ist in verschiedenen Schinittdarstellungen in den Figuren 1A bis 1F dargestellt.

Figur 1A zeigt den Signalübertrager im Querschnitt in einer Schnittebene A-A. Dieser Signalübertrager umfasst eine Primärwicklung 10 und zwei Sekundärwicklungen 20_1, 20_2. Die Sekundärwicklungen 20_1, 20_2 sind durch eine Dielektrikumsschicht 51 gegenüber der Primärwicklung 10 und gegeneinander dielektrisch isoliert.

Die Primärwicklung 10 und die Sekundärwicklungen 20_1, 20_2 sind oberhalb eines Trägersubstrats 40 angeordnet, wobei die Sekundärwicklungen 20_1, 24_2 in dem Beispiel zwischen dem Substrat 40 und der Primärwicklung 10 angeordnet sind. Das Trägersubstrat 40 ist beispielsweise ein Halbleitersubstrat in dem in nicht näher dargestellter Weise Signalverarbeitungsschaltungen für die Verarbeitung von primärseitig in den Übertrager einzuspeisender oder sekundärseitig empfangener Signale integriert sein können.

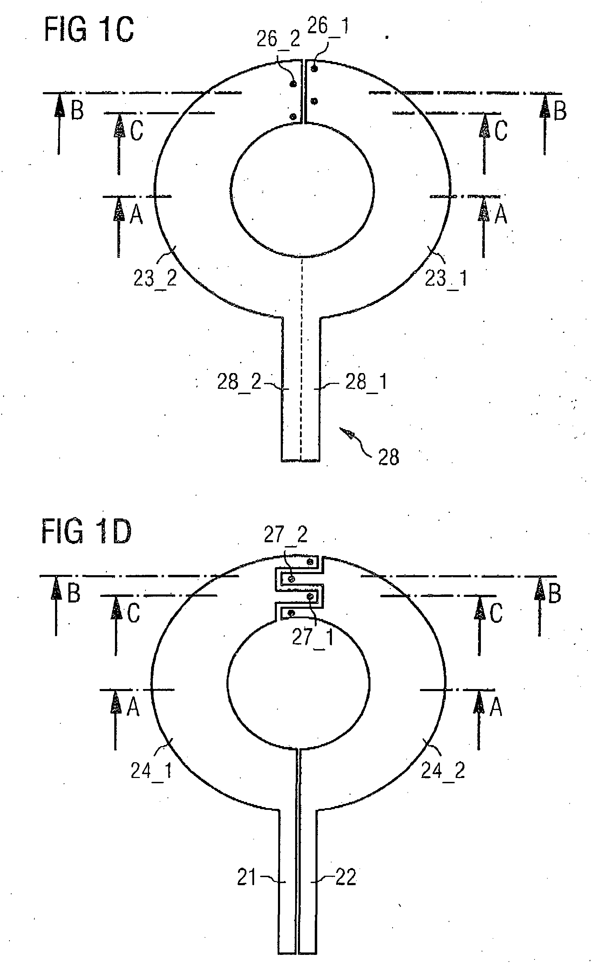

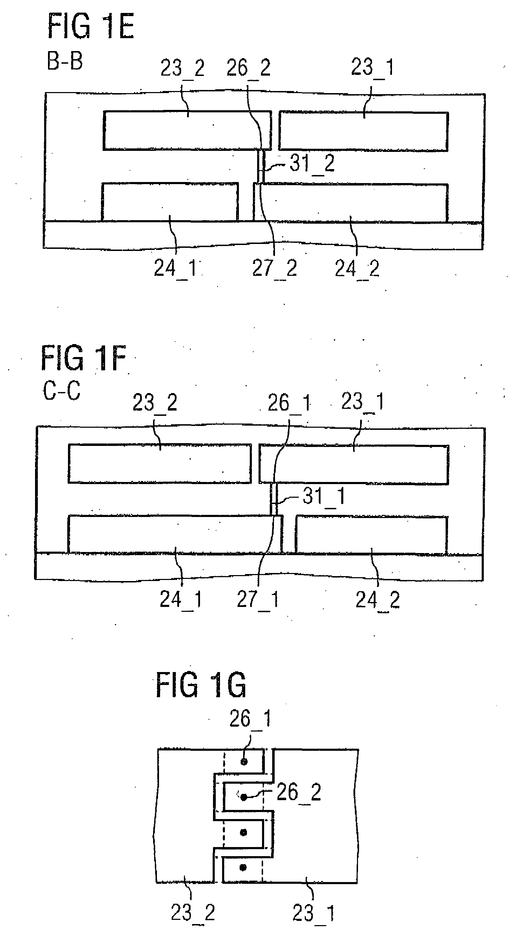

Die Primärwicklung 10, die in Draufsicht in Figur 1B dargestellt ist, ist als planare Wicklung mit mehreren Windungen ausgebildet . Unter einer planaren Wicklung ist hierbei eine Wicklung zu verstehen, deren Windungen in einer einzigen Ebene, die nachfolgend als Wicklungsebene bezeichnet wird, angeordnet ist. Die Wicklungsebene der Primärwicklung ist in dem Beispiel eine parallel zu einer Vorderseite (41 in Figur 1) des Substrats 40 verlaufende Ebene.

Die Primärwicklung 10 und die noch zu erläuternden Sekundärwicklungen 20_1, 20_2 sind in dem Beispiel in sogenannten "Metallisierungsebenen" oberhalb des Substrats angeordnet. Solche Metallisierungsebenen sind Schichten innerhalb einer Isolations- oder Dielektrikumsschicht, innerhalb derer Leiterbahnen aus einem leitenden Material, beispielsweise einem Metall oder einem hochdotierten Polysilizium, realisierbar sind. Solche leitenden Materialien werden nachfolgend ohne Beschränkung der Allgemeingültigkeit als "Metallisierungen" bezeichnet.

Die Primärwicklung 10 besteht in aus einer spiralförmig verlaufenden Leiterbahn in einer Metallisierungsebene und kann durch dieselben Prozesse hergestellt werden, durch welche Leitungsverbindungen in Metallisierungsebenen eines Halbleiterbauelements hergestellt werden. Die Dicke der Metallisierungen der Primärwicklung kann dabei größer sein als die Dicke der Metallisierungen der Sekundärwicklungen.

Die Primärwicklung weist einen ersten Anschluss 11 und einen zweiten Anschluss 12 auf. Der erste Anschluss 11 ist in der Wicklungsebene der Primärwicklung außerhalb des spiralförmigen Wicklungsverlaufs der Primärwicklung angeordnet, wähnend der zweite Anschluss 12 innerhalb des spiralförmigen Wicklungsverlaufs angeordnet ist.

Die beiden Sekundärwicklungen 20_1, 20_2 sind bei dem Signalübertrager jeweils aus mehreren Wicklungsabschnitten, in dem Beispiel jeweils aus zwei Wicklungsabschnitten 23_1, 23**_**2, 24_1, 24_2 aufgebaut, die in unterschiedlichen Wicklungsebenen angeordnet sind. Die Bezugszeichen der Wicklungsabschnitte der ersten Sekundärwicklung 20_1 unterscheiden sich nachfolgend durch den Zusatz _1 von den Wicklungsabschnitten der zweiten Sekundärwicklung 20_2, die mit _2 bezeichnet sind.

Bei dem Signalübertrager gemäß Figur 1 umfassen die beiden Sekundärwicklungen zusammen vier Wicklungsabschnitte 23_1, 23_2, 24-1, 24_2, die paarweise in zwei benachbart zueinander angeordneten Wicklungsebenen angeordnet sind. Ein erstes Paar Wicklungsabschnitte 23_1, 23_2 ist in einer ersten Wicklungsebene angeordnet, die in einer ersten Richtung unmittelbar benachbart zu der Wicklungsebene der Primärwicklung 10 liegt. Die erste Richtung entspricht in dem Beispiel einer vertikalen Richtung des Substrates. Ein weiteres Paar Wicklungsabschnitte 24_1, 24_2 ist in dieser ersten Richtung benachbart zu dem ersten Paar Wicklungsabschnitte 23_1, 23_2 in einer zweiten Wicklungsebene angeordnet. Dieses weitere Paar Wicklungsabschnitte 24_1, 24_2 ist durch eine optional vorhandene Dielektrikumsschicht 52 gegenüber dem Halbleitersubstrat 40 isoliert.

Das erste Paar Wicklungsabschnitte 23_1, 23_2 ist in Draufsicht in Figur 1C und das zweite Paar Wicklungsabschnitte 24_1, 24_2 ist in Draufsicht in Figur 1D dargestellt. Die Wicklungsabschnitte eines Paares sind in einer zweiten Reichtung, die senkrecht zu der ersten Richtung verläuft und die in dem Beispiel einer horizontalen Richtung des Substrats entspricht, benachbart zueinander angeordnet. Die einzelnen Wicklungsabschnitte 23_1 - 24_2 sind jeweils als Kreisringsegmente mit einem Winkel von 180° ausgebildet und bilden jeweils eine halbe Windung der jeweiligen Sekundärwicklung 20_1, 20_2. Die zwei in einer Wicklungsebene angeordneten Wicklungsabschnitte 23_1, 23_2 bzw. 24_1, 24_2 ergänzen sich dabei jeweils zu einem Kreisring mit zwei Ringhälften bzw. Kreisringsegmenten.

Die einzelnen Wicklungsabschnitte 23_1 - 24_2 sind so angeordnet, dass in der ersten Richtung jeweils zwei Wicklungsabschnitte fluchtend übereinander angeordnet sind.

Die durch die Wicklungsabschnitte einer Wicklungsebenen gebildeten Kreisringe und die Primärwicklung 10 sind in der ersten Richtung jeweils übereinander angeordnet. Die Abmessungen eines durch ein Wicklungsabschnittspaar gebildeten Kreisrings in der zweiten Richtung entsprechen in etwa den Abmessungen der Primärwicklung 10. Dies ist gleichbedeutend damit, dass die Primärwicklung 10 die durch die einzelnen Wicklungsabschnittspaare gebildeten Kreisringe weitgehend überdeckt. [wl]

Jede der beiden Sekundärwicklungen 20_1, 20_2 umfasst einen ersten und einen zweiten Wicklungsabschnitt, die in Reihe geschaltet sind und die in dem Beispiel so gewählt sind, dass jede der Sekundärwicklungen 20_1, 20_2 eine Windung aufweist. Die erste Sekundärwicklung 20_1 ist durch den Wicklungsabschnitt 23_1 in der ersten Wicklungsebene und den Wicklungabschnitt 24_1 in der darunter liegenden zweiten Wicklungsebene gebildet. Diese beiden Wicklungsabschnitte 23_1, 24_1 sind in der zweiten Richtung versetzt zueinander angeordnet und ergänzen sich zu einem Kreisring mit zwei in der ersten Richtung zueinander versetzten Ringhälften, der die erste Sekundärwicklung 20_1 bildet.

Die zweite Sekundärwicklung 20_2 ist durch den Wicklungsabschnitt 23_2 in der ersten Wicklungsebene und den Wicklungabschnitt 24_2 in der darunter liegenden zweiten Wicklungsebene gebildet. Diese beiden Wicklungsabschnitte 23_2, 24_2 sind in der zweiten Richtung versetzt zueinander angeordnet und ergänzen sich zu einem Kreisring mit zwei in der ersten Richtung zueinander versetzten Ringhälften, der die zweite Sekundärwicklung 20_2 bildet.

Die erste und die zweite Sekundärwicklung 20_1, 20_2 besitzen bei dem in Figur 1 dargestellten Übertrager einen gemeinsamen Bezugspotentialanschluss 28. Die beiden in der ersten Wicklungsebene angeordneten Wicklungsabschnitte 23_1, 23_2 sind hierbei an einem Ende im Bereich des Bezugspotentialanschlusses 28 einstückig miteinander verbunden. An dem jeweils anderen Ende sind die beiden Wicklungsabschnitte 23_1, 23_2 durch einen Spalt voneinander getrennt, in dem ein Teil der Dielektrikumsschicht 51 angeordnet ist.

Wie durch die gestrichelte Linie in Figur 1C schematisch dargestellt ist, besteht selbstverständlich auch die Möglichkeit, die beiden Wicklungsabschnitte 23_1, 23_2 vollständig voneinander zu trennen und für jeden dieser Wicklungsabschnitte 23_1, 23_2 einen separaten Bezugspotentialanschluss 28_1, 28_2 vorzusehen.

An dem dem Bezugspotentialanschluss 28 abgewandten Ende weisen die Wicklungsabschnitte 23_1, 23_2 jeweils wenigstens einen Verbindungsanschluss 26_1, 26_2 auf. Über diese Verbindungsanschlüsse 26_1, 26_1 sind die Wicklungsabschnitte 23_1, 23_2 der ersten Wicklungsebene über vertikale Leitungsverbindungen 31_1, 31_2 an den jeweils zugehörigen Wicklungsabschnitt 24_1, 24_2 der zweiten Wicklungsebene angeschlossen. Diese vertikalen Leitungsverbindungen sind in den Figuren 1E und 1F dargestellt, die Querschnitte durch den Signalübertrager in Schnittebenen B-B und C-C im Bereich der Verbindungsanschlüsse 26_1, 26_2 zeigen.

Die vertikalen Leitungsverbindungen 31_1, 31_2 sind an entsprechende Verbindungsanschlüsse 27_1, 27_2 der Wicklungsabschnitte 24_1, 24_2 der zweiten Wicklungsebene angeschlossen. Diese Wicklungsabschnitte 24_1, 24_2 weisen im Bereich der Verbindungsanschlüsse 27_1, 27_2 jeweils zahnartige Strukturen auf, die ineinander greifen und die so gestaltet sind, dass die Zahnstruktur des Wicklungsabschnitts 24_1 in der zweiten Richtung bis unter den zugehörigen Wicklungsabschnitt 23_1 des ersten Wicklungsabschnittspaares der ersten Dicklungsebene reicht und dass die Zahnstruktur des Wicklungsabschnitts 24_2 in der zweiten Richtung bis unter den zugehörigen Wicklungsabschnitt 23_2 des ersten Wicklungsabschnittspaares der ersten Wicklungsebene reicht.

Bei dem Ausführungsbeispiel gemäß Figur 1D weisen die wicklungsabschnitte 24_1, 24_2 der zweiten Wicklungsebene 24 zahnartige Strukturen auf, während die Kanten der wicklungsabschnitte 23_1, 23_2 der ersten Wicklungsebene 23 geradlinig verlaufen. Diese Anordnung kann selbstverständlich vertauscht werden, so dass die Wicklungsabschnitte der ersten Micklungsebene in nicht näher dargestellter Weise zahnartige Strukturen aufweisen, während die Kanten der Wicklungsabschnitte der zweiten Wicklungsebenen geradlinig verlaufen.

Bezugnehmend auf die in Figur 1G dargestellte Alternative können außerdem sowohl die Wicklungsabschnitte der ersten wicklungsebene 23 als auch die Wicklungsabschnitte der zweiten Wicklungsebenen 24 zahnartige Strukturen aufweisen. Die Zahnstruktur der ersten Wicklungsebene 23, die in Figur 1G in Draufsicht dargestellt ist, ist dabei derart versetzt zu der Zahnstruktur der zweiten Wicklungsebene 24 angeordnet, dass die Zähne eines Wicklungsabschnittes einer Ebene die Zähne des jeweils versetzt angeordneten Wicklungsabschnitts der anderen Ebene überlappen. Die Position der Zähne der Zahnstruktur der zweite Wicklungsebene ist in Figur 1G gepunktet dargestellt. Die Anschlusskontakte 26_1, 26_2 können bei dieser Alternative auf einer geraden Linie angeordnet sein.

Die beiden Sekundärwicklungen 20_1, 20_2, die jeweils zwei versetzt zueinander angeordnete und in Reihe geschaltete Wicklungsabschnitte 23_1, 24_1 bzw. 23_2, 24_2 aufweisen, sind bezogen auf die Primärwicklung 10 vollkommen symmetrisch aufgebaut, so dass die beiden Sekundärwicklungen 20_1, 20_2 unter identischen Bedingungen an die Primärwicklung 10 gekoppelt sind. Dies betrifft sowohl die hinsichtlich der Signalübertragung erwünschte induktive Kopplung der beiden Sekundärwicklungen 20_1, 20_2 an die Primärwicklung 10, als auch die unvermeidliche kapazitive Kopplung der Primärwicklung 10 an die beiden Sekundärwicklungen 20_1, 20_2.

Bei dem dargestellten Beispiel besitzen die beiden Sekundärwicklungen mit dem Bezugspotentialanschluss 28 einen gemeinsamen Anschluss und jeweils einen zusätzlichen Ausgangsanschluss 21, 22. Diese Ausgangsanschlüsse 21, 22 sind an den Wicklungsabschnitten 24_1, 24_2 der zweiten Wicklungsebene an Enden angeordnet, die den Enden mit den Verbindungsanschlüssen 27_1, 27_2 gegenüberliegen.

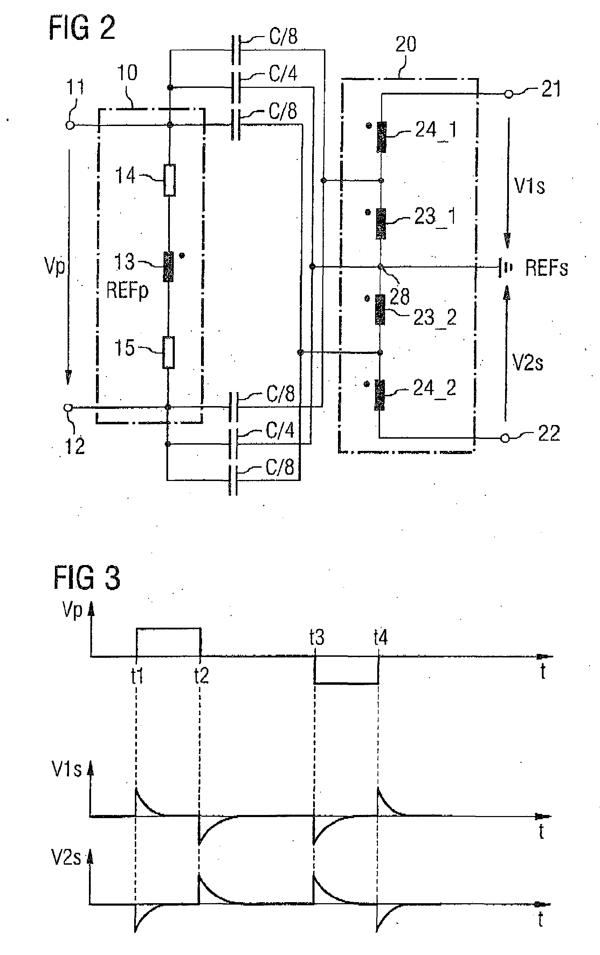

Das elektrische Ersatzschaltbild des zuvor anhand von Figur 1 erläuterten Signalübertragers ist in Figur 2 dargestellt. Das Ersatzschaltbild der Primärwicklung 10 umfasst eine Induktivität 13, die die Induktivität der Primärwicklung 10 repräsentiert, sowie zwei ohmsche Widerstände 14, 15, die symmetrisch um die Induktivität 13 angeordnet sind, und die die unvermeidlichen ohmschen Bahnwiderstände der Primärwicklung 10 repräsentierten.

Auf die Darstellung der Bahnwiderstände der einzelnen Wicklungsabschnitte der Sekundärwicklung 20 ist in Figur 2 aus Gründen der Übersichtlichkeit verzichtet. Die Sekundärwicklung 20 umfasst vier Induktivitäten, die in Figur 2 entsprechend der Wicklungsabschnitte 23_1 - 24_2, durch welche sie gebildet sind, bezeichnet sind. Von diesen Induktivitäten sind jeweils zwei in Reihe zwischen den Bezugspotentialanschluss 28 und einen der Ausgangsanschlüsse 21, 22 geschaltet. Die parasitäre kapazitive Kopplung der Sekundärwicklung 20 an die Primärwicklung 10 ist in Figur 2 durch Kapazitäten dargestellt, die jeweils zwischen den Anschlüsse 11, 12 der Primärwicklung 10 und den Verbindungen zwischen den einzelnen Induktivitäten wirksam sind. Es sei angenommen, dass der Gesamtwert einer Kopplungskapazität der Primärwicklung 10 und der Sekundärwicklung 20 einem Wert C entspricht. Die zwischen den Anschlüssen 11, 12 der Primärwicklung 10 und den einzelnen Verbindungspunkten der Sekundärwicklung 20 wirksamen anteile dieser Gesamtkapazität sind in Figur 2 durch sechs Kondensatoren dargestellt, deren Kapazitätswert jeweils einem Anteil der Gesamtkapazität C entspricht.

Aufgrund der symmetrischen Anordnung der Sekundärwicklungen 20_1, 20_2 bezogen auf die Primärwicklung 10 ist die kapazitive Kopplung des ersten und zweiten Anschlusses 11, 12 der Primärwicklung 10 an die Sekundärwicklungen 20_1, 20_2 jeweils gleich. Die parasitäre Koppelkapazität zwischen der Primär- und der Sekundärseite ist somit symmetrisch auf die primärseitigen und sekundärseitigen Anschlüsse verteilt. Während eines noch zu erläuternden Betriebs des Signalübertragers sind die Sekundärwicklungen 20_1, 20_2 über den Bezugspotentialanschluss 28 an ein gemeinsames sekundärseitiges Bezugspotentials REFs angeschlossen und eine Spannung zwischen den dem Bezugspotentialanschluss 28 abgewandten Anschlüssen 21, 22 der Sekundärwicklungen 20_1, 20_2 wird zur Ermittlung eines gesendeten Signals ausgewertet. Ein während eines solchen Betriebs auf der Primärseite auftretendes Gleichtaktstörsignal, also ein Signal, dass in gleicher Weise auf den ersten und zweiten Anschluss 11, 12 der Primärwicklung 10 wirkt, bewirkt sekundärseitig ein entsprechendes Gleichtaktsignal an den ersten und zweiten Anschlüssen 21, 22 der Sekundärwicklung gegenüber dem Bezugspotentialanschluss 28 bzw. gegenüber dem sekundärseitigen Bezugspotential REFs. Ein solches Gleichtaktstörsignal kann auf noch zu erläuternde Weise einfach als Störsignal erkannt und dadurch eliminiert werden.

Schließt man den gemeinsamen Bezugspotentialanschluss 28 der Sekundärwicklungen während des Betriebs des Signalübertragers an eine geeignetes sekundärseitiges Bezugspotential REFs an, so sind bei einer primärseitigen Anregung des Übertrager zwischen den Ausgängen 21, 22 der Sekundärwicklungen 20_1, 20_2 und dem sekundärseitigen Bezugspotential REFs jeweils komplementäre Signalverläufe vorhanden, was nachfolgend anhand von Figur 3 erläutert wird.

Figur 3 zeigt zeitliche Verläufe einer ersten Sekundärspannung V1s zwischen dem ersten Ausgangsanschluss 21 und dem Bezugspotentialanschluss 28 und einer zweiten Sekundärspannung V2s zwischen dem zweiten Ausgangsanschluss 22 und dem Bezugspotentialanschluss 28 für zwei verschiedene primärseitig an den Signalübertrager angelegte Signalimpulse.

Zur Erläuterung des Übertragungsverhaltens sei angenommen, dass primärseitig wahlweise ein positiver Signalimpuls oder ein negativer Signalimpuls jeweils für eine Zeitdauer angelegt werden kann. Ein positiver Signalimpuls ist dabei gleichbedeutend mit einem positiven Signalimpuls am ersten Anschluss 11 gegen ein primärseitiges Bezugspotential REFp; während der zweite Anschluss 12 auf diesem primärseitigen Bezugspotential REFp liegt. Ein negativer Sendeimpuls ist dabei gleichbedeutend mit einem positiven Signalimpuls an dem zweiten Eingang 12, während der erste Eingang 11 auf dem primärseitigen Bezugspotential REFp liegt.

In Figur 3 sind zeitlich aufeinanderfolgend ein positiver primärseitiger Signalimpuls, der eine steigende Flanke zu einem Zeitpunkt t1 und eine fallende Flanke zu einem Zeitpunkt t2 aufweist, sowie ein negativer primärseitiger Signalimpuls, der eine fallende Flanke zu einem nach dem Zeitpunkt t2 liegenden Zeitpunkt t3 und eine steigende Flanke zu einem Zeitpunkt t4 aufweist, dargestellt. Die steigende Flanke des positiven Impuls zum Zeitpunkt t1 führt zu einem positiven Signal impuls der ersten Sekundärspannung Vs der im weiteren Verlauf exponentiell abnimmt, und zu einem negativen Signalimpuls der zweiten Sekundärspannung V2s, dessen Amplitude im weiteren Verlauf exponentiell abnimmt. Die negative Flanke zum Zeitpunkt t2 des positiven Signalimpulses bewirkt einen negativen Impuls der ersten Sekundärspannung V1s, dessen Amplitude im weiteren Verlauf exponentiell annimmt, und einen positiven Impuls der zweiten Sekundärspannurig V2s, deren Amplitude im weiteren Verlauf ebenfalls exponentiell abnimmt. Die positiven und negativen Flanken des negativen Signalimpulses führen zu entsprechenden Signalverläufen der ersten und zweiten Sekundärspannung V1s, V2s wie die positiven und negativen Flanken des positiven Signalimpulses.

Die zuvor erläuterte Funktionsweise des Signalübertragers wird dadurch erreicht, dass einzelnen Wicklungsabschnitte 23_1 - 24_2 einer Sekundärwicklung 20_1, 20_2 so miteinander verschaltet sind, dass sich Spannungen, die in den einzelnen Wicklungsabschnitten 23_1 - 24_2 bei Anregung der Primärwicklung 10 induziert werden, addieren. Die erste und die zweite Sekundärwicklung 20_1, 20_2 sind dabei so verschaltet, dass in diesen Sekundärwicklungen jeweils bezogen auf den Bezugspotentialanschluss Spannungen mit entgegengesetzten Vorzeichen induziert werden. Die in den einzelnen Wicklungsabschnitten der ersten Sekundärwicklung durch die Primärwicklung induzierten Spannungen addieren sich somit in umgekehrter Reihenfolge als die in den einzelnen Wicklungsabschnitten der zweiten Sekundärwicklung durch die Primärwicklung induzierten Spannungen. Geometrisch betrachtet ist dies gleichbedeutend damit, dass ein durch die Wicklungsabschnitte 23_1, 24_1 der ersten Sekundärwicklung 20_1 gebildeter Kreisring ausgehend von dem Bezugspotentialanschluss 28 zu dem Anschluss 11 in einer Richtung verläuft, die entgegengesetzt ist zu einer Richtung, in der ein durch die Wicklungsabschnitte 23_2, 24_2 der zweiten Sekundärwicklung 20_2 gebildeter Kreisring ausgehend von dem Bezugspotentialanschluss 28 zu dem Anschluss 12 verläuft.

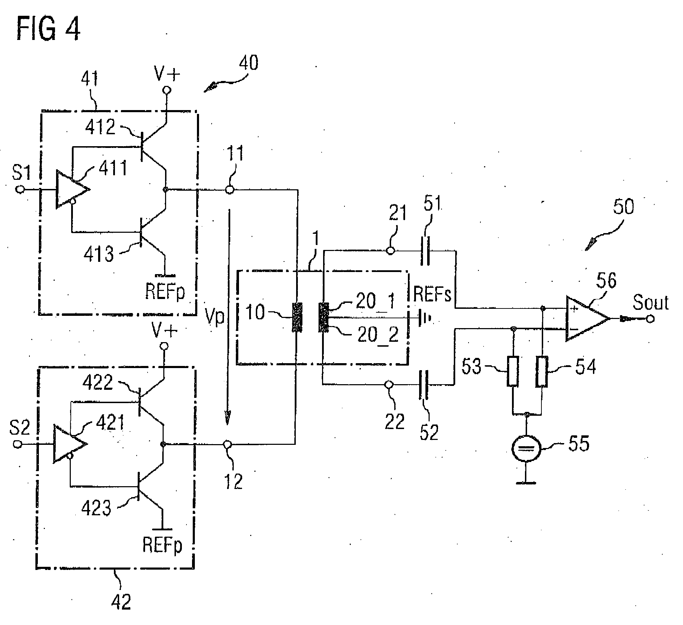

Figur 4 zeigt eine Signalübertragungsvorrichtung mit einem zuvor erläuterten Signalübertrager 1. Die Sekundärwicklungen 20_1, 20_2 sind bei diesem Signalübertrager miteinander verbunden und gemeinsam an das sekundärseitige Bezugspotential REFs angeschlossen.

Sekundärseitig weist die Signalübertragungsvorrichtung eine Empfangsvorrichtung 50 auf, die an die Ausgänge 21, 22 der miteinander verbundenen Sekundärwicklungen 20_1, 20_2 angeschlossen ist. Diese Empfangsvorrichtung 56 weist einen Differenzverstärker 56 auf, der die Differenz der an den Ausgängen 21, 22 anliegenden Sekundärspannungen (V1s, V2s in Figur 2) bildet und der ein von dieser Differenz abhängiges Ausgangssignal Sout zur Verfügung stellt. Die Eingänge des Dieferenzverstärkers sind bei diesem Empfänger über Kondensatoren 51, 52 gegenüber den Anschlüssen 21, 22 der Sekundärwicklungen entkoppelt. Diese Kondensatoren 51, 52 dienen dazu, die Ausgänge 21, 22 der Sekundärwicklungen gleichspanriungsmäßig von den Eingängen des Differenzverstärkers 56 zu trennen. Die bei einer Signalübertragung an den Ausgängen 21, 22 anliegenden Signalimpulse (vgl. Figur 3) werden durch diese Kondensatoren 51, 52 jedoch an die Eingänge des Differenzverstärkers 56 übertragen. An die Eingänge des Differenzverstärkers ist über Widerstände 53, 54 außerdem eine Spannungsquelle angeschlossen, die dazu dient, den Arbeitspunkt des Differenzverstärkers 56 einzustellen.

Der zeitliche Verlauf eines Ausgangssignals Sout des Differenzverstärkers 56 entspricht bei einer in Figur 3 dargestellten primärseitigen Anregung des Signalübertragers 1 der Differenz des ersten Sekundärspannungssignals V1s und des zweiten Sekundärspannungssignals V2s. Da diese Sekundärsignale jeweils komplementär zueinander sind, entspricht der Signalverlauf des Ausgangssignals Sout dem Signalverlauf der ersten Sekundärspannung Vs1, allerdings mit der doppelten Amplitude. Besitzt der Differenzverstärker 56 eine Verstärkung ungleich Eins, so weist das Ausgangssignal Sout eine Amplitude auf, die dem Doppelten der Signalamplitude der Sekundärspannungen Vs1, Vs2 multipliziert mit dem Verstärkungsfaktor des Differenzverstärkers 56 entspricht.

Ein primärseitig auftretendes Gleichtaktstörsignal führt aufgrund des symmetrischen Aufbaus des Signalübertragers zu gleichen Sekundärspannungen Vs1, Vs2 gegen das sekundärseitige Bezugspotential REFs. Die Differenz dieser Signale ist Null, so dass das Ausgangssignal des Differenzverstärkers 56 bei Auftreten eines Gleichtaktstörsignals ebenfalls Null ist.

Dem Differenzverstärker 56 kann in nicht näher dargestellter Weise eine Auswerteschaltung mit einem Schwellenwertdetektor nachgeschaltet sein, die das Ausgangssignal Sout des Differenzverstärkers auswertet, um das primärseitige Sende Signal Vp zu rekonstruieren.

Primärseitig weist die in Figur 4 dargestellte Signalübertragungsvorrichtung eine Treiberschaltung 40 mit zwei Treibern 41, 42 auf, von der ein erster Treiber 41 an den ersten Anschluss 11 der Primärwicklung 10 und ein zweiter Treiber 42 an den zweiten Anschluss 12 der Primärwicklung 10 angeschlossen ist. Diese beiden Treiberschaltungen 41, 42 sind jeweils dazu ausgebildet, die Anschlüsse 11, 12 der Primärwicklung 10 nach Maßgabe eines Steuersignals S1, S2 an ein positives Versorgungspotential V+ oder an primärseitiges Bezugspotential REFp anzuschließen. Die Treiberschaltungen 41, 42 weisen jeweils eine Halbbrückenschaltung mit zwei Transistoren 412, 413, 422, 423 auf. Die Transistoren einer Treiberschaltung 41, 42 sind dabei über einen Treiber 411, 421 abhängig von dem jeweiligen Steuersignal S1, S2 komplementär zueinander angesteuert, so dass nur jeweils ein Transistor der jeweiligen Halbbrücke leitend angesteuert ist.

Die Funktionsweise der in Figur 4 dargestellten Treiberschaltung 40 wird nachfolgend unter Verwerdung der in Figur 3 dargestellten Signalfolge der Primärspannung Vp erläutert. Zur Erzeugung des positiven Signalimpulses ab dem Zeitpunkt t1 wird der erste Anschluss 11 über die erste Treiberschaltung 41 ab dem Zeitpunkt t1 an das positive Versorgungspotential V+ angeschlossen. Das Steuersignal S1 nimmt hierzu beispielsweise einen High-Pegel an, wodurch der obere Transistor (High-Side-Transistor) 412 der Halbbrücke leitet, während der untere Transistor (Low-Side-Transistor) sperrt. Zum Zeitpunkt t2 wird der erste Anschluss 11 an das primärseitige Bezugspotential REFp angeschlossen, was dadurch erreicht wird, das das Steuersignal S1 zu diesem Zeitpunkt einen Low-Pegel annimmt, bei dem der obere Transistor 412 sperrt und der untere Transistor 413 leitet.

Zur Erzeugung des negativen Signalimpulses ab dem Zeitpunkt t3 wird der zweite Anschluss 12 zum Zeitpunkt t3 über die zweite Treiberschaltung 42 an das Versorgungspotential V+ angeschlossen, was dadurch erreicht wird, dass das zweite Steuersignal S2 zu diesem Zeitpunkt einen High-Pegel annimmt. Ab dem Zeitpunkt t4 wird der zweite Anschluss 12 der Primärwicklung 10 an das primärseitige Bezugspotential REFp angeschlossen, was dadurch erreicht wird, dass das zweite Steuersignal S2 ab diesem Zeitpunkt einen Low-Pegel annimmt.

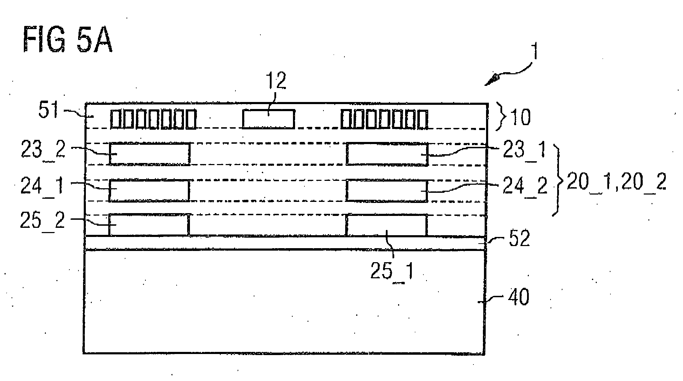

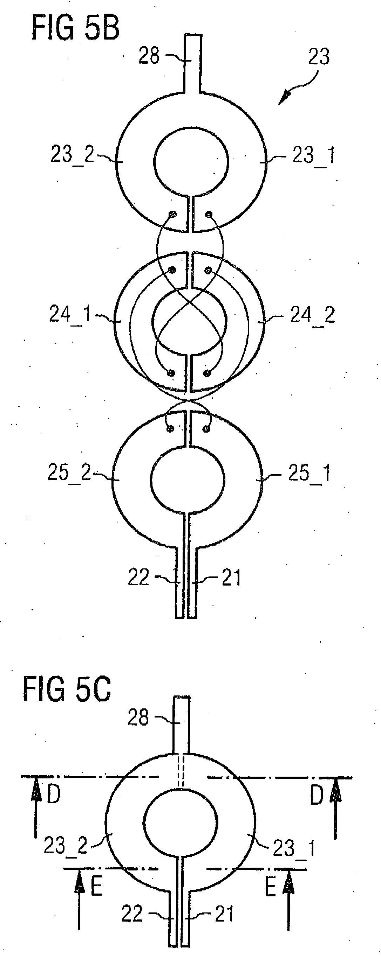

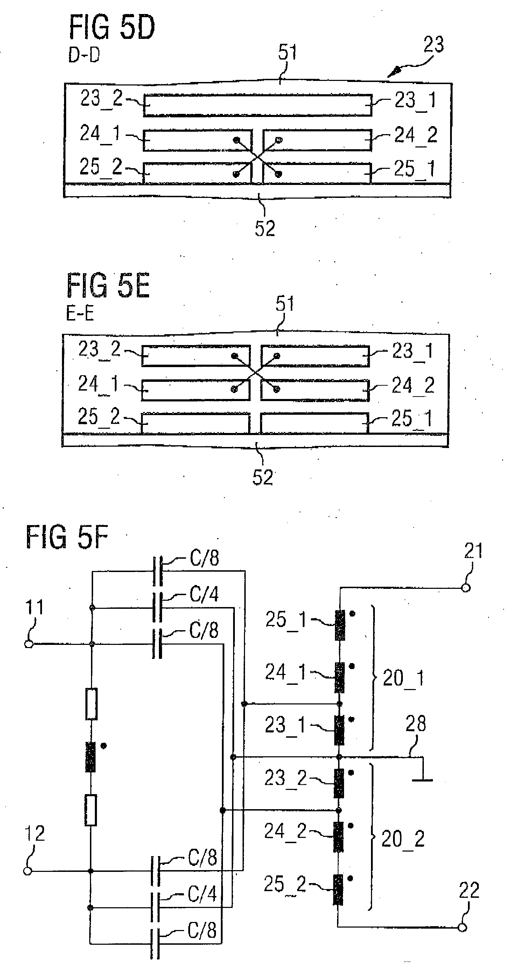

Figur 5 zeigt ein weiteres Ausführungsbeispiel eines erfindungsgemäßen Signalübertragers. Dieser Signalübertrager unterscheidet sich von dem anhand von Figur 1 erläuterten Signalübertrager dadurch, dass die beiden Sekundärwicklungen 20_1, 20_2 jeweils drei in Reihe geschaltete Wicklungsabschnitte, nämlich die Wicklungsabschnitte 23_1, 24_1, 25_1 für die erste Sekundärwicklung 20_1 und die Wicklungsabschnitte 23_2, 24_2, 25_2 für die zweite Sekundärwicklung 20_2, aufweisen. Figur 5A zeigt diesen Signalübertrager 1 im Querschnitt durch die Primärwicklung 10 und die einzelnen Wicklungsabschnitte der Sekundärwicklungen 20_1, 20_2. Jeweils zwei Wicklungsabschnitte, von denen einer der ersten Sekundärwicklung 20_1 und der andere der zweiten Sekundärwicklung 20_2 zugeordnet ist, bilden ein Wicklungsabschnittspaar und sind in einer Wicklungsebene angeordnet. Die Wicklungsabschnittspaare der drei Wicklungsebenen sind in der ersten Richtung übereinander angeordnet und sind in dieser ersten Richtung auf die Primärwicklung 10 ausgerichtet.

Die Geometrie der einzelnen Wicklungsabschnitte und deren gegenseitige Verschaltung ist aus Figur 5B ersichtlich, in der die einzelnen Wicklungsabschnitte in Draufsicht untereinander, beginnend mit den Wicklungsabschnitten 23_1, 23_2 der unmittelbar zu der Primärwicklung 10 benachbarten Wicklungsebene, dargestellt sind. Die elektrischen Verbindungen der einzelnen wicklungsabschnitte sind in Figur 5B durch schematisch dargestellte Leitungsverbindungen veranschaulicht. Die Wicklungsabschnitte 23_1, 23_2 der ersten Wicklungsebene besitzen bei dem Beispiel einen gemeinsamen Bezugspotentialanschluss 28 und sind im Bereich dieses Bezugspotentialanschlusses 28 einstückig miteinander verbunden.

Figur 5C zeigt eine Draufsicht auf die übereinander angeordneten Wicklungsabschnitte des Signalübertragers und die Figuren 5D und 5E zeigen Querschnitte durch die in Figur 5C dargestellten Schnittebenen D-D und E-E. Diese Querschnitte zeigen den Signalübertrager in den Bereichen, in denen die einzelne Wicklungsabschnitte eines Wicklungsabschnittpaares jeweils durch Spalte voneinander getrennt sind. In diesen Figuren 5D und 5E sind schematisch außerdem elektrische Leitungsverbindungen zwischen den einzelnen Wicklungsabschnitten veranschaulicht, die dazu dienen, die zu einer Sekundärwicklung gehörenden Wicklungsabschnitte jeweils in Reihe zu schalten. Die einer Sekundärwicklung 20_1, 20_2 zugeordneten Wicklungabschnitte sind dabei in den einzelnen Wicklungsebenen in der zweiten Richtung versetzt zueinander angeordnet. Um zwei solche versetzt zueinander angeordnete Wicklungsabschnitte elektrisch leitend miteinander verbinden zu können, können die einzelnen Wicklungsabschnitte des in Figur 5 dargestellten Signalübertragers entsprechend der Wicklungsabschnitte des in Figur 1 dargestellten Signalübertragers zahnartige Strukturen mit Verbindungsanschlüssen aufweisen, die entsprechend der Erläuterungen zu den Figuren 1E und 1F über vertikale Leitungsverbindungen miteinander verbunden werden können.

Das elektrische Ersatzschaltbild des bisher anhand der Figuren 5A bis 5E erläuterten Signalübertragers ist in Figur 5F dargestellt. Dieses Ersatzschaltbild umfasst sechs Induktiviträten, von denen jeweils drei in Reihe zwischen einen der Sekundärwicklungsanschlüsse 21, 22 und den Bezugspotentialanschluss 28 geschaltet sind. Diese drei in Reihe geschaltete Induktivitäten bilden jeweils eine der Sekundärwicklungen 20_1, 20_2.

Die bisher erläuterten Signalüberträger weisen jeweils zwei Sekundärwicklungen 20_1, 20_2 auf, von denen jede jeweils wenigstens zwei Wicklungsabschnitte umfasst, wobei die einzelnen Wicklungsabschnitte in unterschiedlichen Wicklungsebenen angeordnet sind. Die Wicklungsabschnitte einer Sekundärwicklung sind in benachbarten Wicklungsebenen dabei versetzt zueinander angeordnet. Jeder dieser Wicklungsabschnitte bildet, eine halbe Windung, d. h. überstreicht einen Winkel von 180°. Bei diesen Signalübertragern sind jeweils die Wicklungsabschnitte, die einer Sekundärwicklung zugeordnet sind und die in zwei benachbarten Wicklungsebenen angeordnet sind, jeweils um 180° zueinander versetzt angeordnet.

Mit dem zuvor erläuterten Konzept lassen sich auch Signalübertrager mit einer Primärwicklung und mehr als zwei Sekundärwicklungen realisieren, wobei die einzelnen Sekundärwicklungen jeweils in gleicher Weise induktiv mit der Primärwicklung gekoppelt sind. Um n (mit n>2) Sekundärwicklungen mit jeweils einer Windung zu realisieren, sind hierbei n Wicklungsebenen erforderlich, wobei in jeder Wicklungsebene n Wicklungsabschnitte vorhanden sind, die jeweils ein Kreisringsegment mit einem Winkel von 360°/n bilden. Zur Realisierung einer Sekundärwicklung sind n solcher Wicklungsabschnitte in Reihe geschaltet, wobei für jede Sekundärwicklung nur ein Wicklungsabschnitt in einer Wicklungsebene vorhanden ist. Die einzelnen Wicklungsabschnitte eine Sekundärwicklung sind dabei von Wicklungsebene zu Wicklungsebene um einen Winkel versetzt zueinander angeordnet, der 360° /n entspricht.

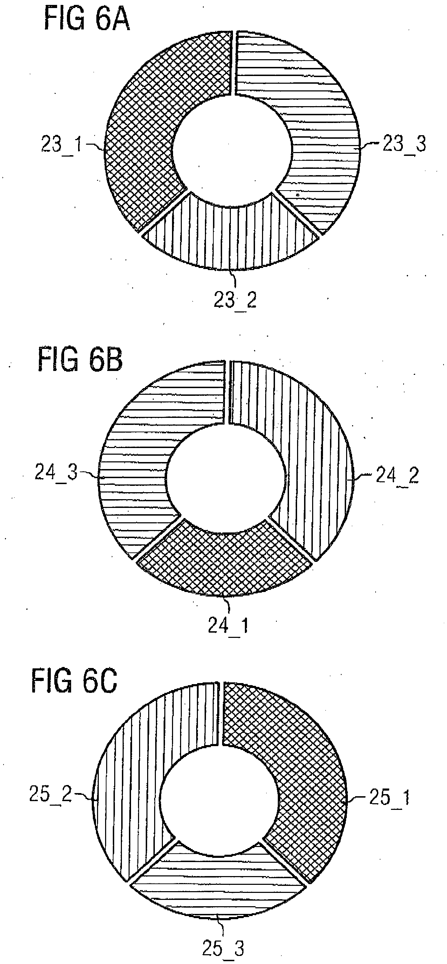

Die Sekundärwicklungen eines solchen Signalübertragers mit mehr als zwei Sekundärwicklungen sind für einen Signalübertrager mit drei Sekundärwicklungen in den Figuren 6A bis 6C dargestellt.

Figur 6A zeigt die Wicklungsabschnitte einer ersten Wicklungsebene, die beispielsweise unmittelbar benachbart zu einer Primärwicklung (nicht dargestellt) angeordnet ist. Figur 6B zeigt die Wicklungsabschnitte einer zweiten Wicklungsebene, die unmittelbar benachbart zu der ersten Wicklungsebene liegt. Figur 6C zeigt die Wicklungsabschnitte einer dritten Wicklungsebene, die unmittelbar benachbart zu der zweiten Wicklungsebene liegt.

Die einzelnen Wicklungsabschnitte bilden Kreisringsegmente mit jeweils einem Winkel von 120°, wobei die einzelnen Wicklungsabschnitte einer Wicklungsebene durch Spalten, die mit einem Dielektrikum (nicht dargestellt) gefüllt sind, voneinander getrennt sind. Entsprechend der einzelnen Wicklungsab-, schnitte der zuvor erläuterten Signalübertrager sind jeweils drei Wicklungsabschnitte in der ersten Richtung übereinander angeordnet, so dass jeweils ein Wicklungsabschnitt einer Wicklungsebene benachbart zu einem Wicklungsabschnitt einer benachbarten Wicklungsebene liegt und auf diesen Wicklungsabschnitt der benachbarten Wicklungsebene ausgerichtet ist. Eine erste der drei Sekundärwicklungen ist durch einen Wicklungsabschnitt 23_1 in der ersten Wicklungsebenen, einen Wicklungsabschnitt 24_1 in der zweiten Wicklungsebenen und einen Wicklungsabschnitt 25_1 in der dritten Wicklungsebene gebildet. Der Wicklungsabschnitt 24_1 der zweiten Wicklungsebene ist dabei gegen den Uhrzeigersinn um 120° gegenüber dem Wicklungsabschnitt 23_1 der ersten Wicklungsebene versetzt, und der Wicklungsabschnitt 25_1 der dritten Wicklungsebene ist gegen den Uhrzeigersinn und 120° gegenüber dem Wicklungsabschnitt 24_1 der zweiten Wicklungsebene versetzt. Die zweite Sekundärwicklung ist durch Wicklungsabschnitte 23_2, 24_2, 25_2 gebildet, die in Reihe geschaltet sind und die von Wicklungsebene zu Wicklungsebene jeweils gegen den Uhrzeigersinn um 120° zueinander versetzt sind. In entsprechender Weise ist die dritte Sekundärwicklung durch Wicklungsabschnitte 23_3, 24_3, 25_3 gebildet, die in Reihe geschaltet sind und die von Wicklungsebene zu Wicklungsebene jeweils gegen den Uhrzeigersinn um 120° zueinander versetzt sind.

Die Wicklungsabschnitte der unterschiedlichen Wicklungsebenen, die jeweils eine Sekundärwicklung bilden, sind in den Figuren 6A bis 6C durch jeweils gleiche Schraffuren veranschaulicht. Diese Wicklungsabschnitte können in nicht näher dargestellter Weise zahnartige Strukturen mit Verbindungsanschlüssen aufweisen, um zwei in benachbarten Wicklungseben angeordnete Wicklungsabschnitte auf die in den Figuren 1E und 1F erläuterte Weise elektrisch miteinander verbinden zu können.

Bei den anhand der Figuren 1 und 5 erläuterten Signalübertragern stehen sekundärseitig an den Anschlüssen 21, 22 gegen das sekundärseitige Bezugspotential REFs an dem Anschluss 28 zwei gegenphasige Sekundärsignale zur Verfügung. Die zwei Sekundärwicklungen 20_1, 20_2 haben hierbei aufgrund des symmetrischen Aufbaus des Signalübertragers gleiche Koppelkapazitäten zur Primärwicklung 10 und sind auf gleiche Weise induktiv bzw. magnetisch an die Primärwicklung 10 gekoppelt. Bei primärseitig auftretenden Gleichtaktstörsignalen sind die Sekundärsignale dadurch genau gleich und werden von einem Differenzverstärker im Idealfall nicht weiter verarbeitet.

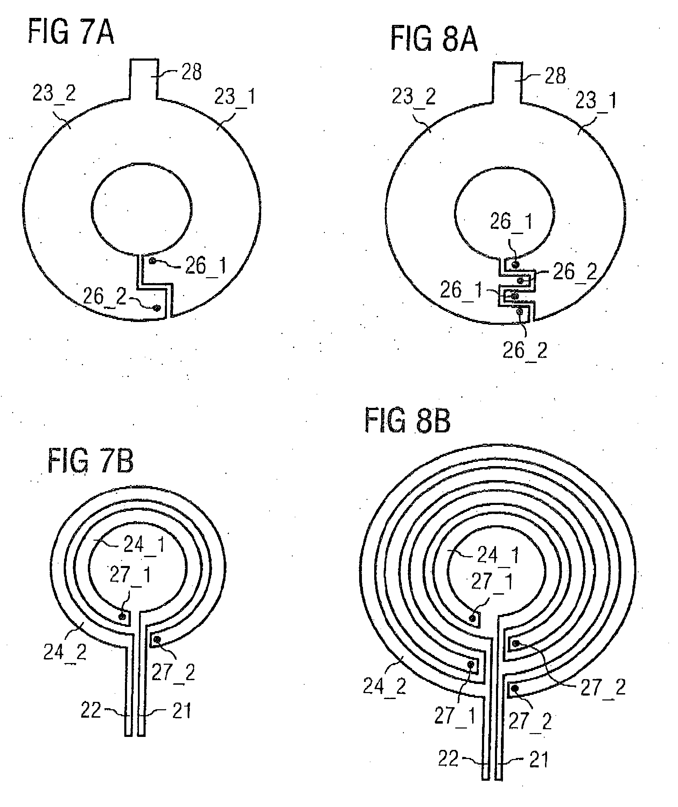

Ein weiteres Beispiel für die Realisierung zweier Sekundärwicklungen eines Signalübertragers mit einer Primärwicklung und zwei Sekundärwicklungen ist in den Figuren 7A und 7B dargestellt. Die nicht dargestellte Primärwicklung dieses Übertragers entspricht beispielsweise der in Figur 1B dargestellten Primärwicklung.

Die Sekundärwicklungen dieses Übertragers umfassen jeweils zwei Wicklungsabschnitte 23_1, 24_1 bzw. 23_2, 24_2, von denen jeweils ein erster 23, 1, 23_2 in einer ersten Wicklungsebene und je ein zweiter 24, 1, 24_2 in einer zweiten Wicklungsebene angeordnet sind. In Figur 7A sind die in der ersten Wicklungsebene angeordneten ersten Wicklungsabschnitte 23_1, 23_2 in Draufsicht dargestellt. Figur 7B zeigt die in der zweiten Wicklungsebene angeordneten zweiten Wicklungsabschnitte 24_1, 24_2 in Draufsicht. Die ersten Wicklungsabschnitte 23_1, 23_2 sind entsprechend der Ausführungsformen in der Figuren 1C und 5B beispielsweise als Kreisringsegmente ausgebildet und besitzen einen gemeinsamen Bezugspotentialanschluss 28.

Die zwei zweiten Wicklungsabschnitte 24_1, 24_2 sind bei dieser Anordnung als konzentrische offene, d.h. nicht vollständig geschlossene, Kreisringe realisiert. Jeder dieser Kreisringe weist an einem Ende einen Verbindungsanschluss 27_1, 27_2 auf. Diese Verbindungsanschlüsse 27_1, 27_2 sind so angeordnet, dass sie in der ersten Richtung über bzw. unter einem entsprechenden Verbindungsanschluss 26_1, 26_2 des zugehörigen ersten Wicklungsabschnitts 23_1, 23_2 liegen. Die ersten Wicklungsabschnitte 23_1, 23_2 können in dargestellter Weise im Bereich der Verbindungsanschlüsse eine Zahnstruktur aufweisen. Enden der Kreisringe 24_1, 24_2, die den Enden mit den Verbindungsanschlüssen 27_1, 27_2 gegenüberliegen, bilden Ausgängsanschlüsse 21, 22 des Sekundärwicklungen. An die Kreisringe schließen sich in diesen Bereichen Leiterabschnitte an, die sich im wesentlichen parallel zueinander von den Kreisringen 24_1, 24_2 weg erstrecken und die eine einfache Kontaktierung der Sekundärwicklungen ermöglichten.

Eine Abwandlung der in Figur 7B dargestellten zweiten Wicklungsabschnitte ist in Figur 8B dargestellt. Diese zweiten Wicklungsabschnitte 24_1, 24_2 weisen jeweils mehreren, in dem Beispiel zwei, konzentrische offene Kreisringe auf. Die Kreisringe eines Wicklungsabschnittes sind dabei an einem Ende mittels eines Leiterabschnitts miteinander verbunden. Diese Leiterabschnitte bilden die Ausgangsanschlüsse 21, 22 der Sekundärwicklungen. Die offenen Kreisringe der zwei Wicklungsabschnitte 24_1. 24_2 sind ausgehend von einem gemeinsamen Zentrum abwechselnd angeordnet, so dass die Kreisringe der beiden Wicklungsabschnitte 24_1, 24_2 "ineinander verzahnt" sind.

An den Enden mit den Leiterabschnitten gegenüberliegenden Enden weisen die Kreisringe jeweils Verbindungsanschlüsse 27_1, 27_2 auf, die so angeordnet sind, dass sie in der ersten Richtung über bzw. unter einem entsprechenden Verbindungsanschluss 26_1, 26_2 des zugehörigen ersten Wicklungsabschnitts 23_1, 23_2 liegen. Die ersten Wicklungsabschnitte 23_1, 23_2 können in dargestellter Weise im Bereich der Verbindungsanschlüsse eine Zahnstruktur aufweisen.

Hinsichtlich der magnetischen Kopplung sind die anhand der Figuren 7 und 8 erläuterten Signalübertrager nicht mehl exakt symmetrisch bezogen auf die sekundären Ausgänge. Die Unsymmetrie hinsichtlich der magnetischen Kopplung ist bei der Anordnung gemäß Figur 8 dabei geringer als bei der Anordnung gemäß Figur 7. Die Signalübertrager der Figuren 7 und 8 sind hinsichtlich der Auswirkung der Koppelkapazitäten zwischen Primär- und Sekundärwicklung vollkommen symmetrisch.

Das Ersatzschaltbild der Signalübertrager der Figuren 7 und 8 entspricht dem in Figur 2 dargestellten mit dem einzigen Unterschied, dass die Sekundärinduktivitäten 24_1 und 24_2 wesentlich größer sind als die Induktivitäten der ersten Wicklungsabschnitte 23_1 und 23_2.

## Patentansprüche

1. Signalübertrager, der aufweist:
eine Primärwicklung (10),
eine erste und wenigstens eine zweite Sekundärwicklung (20_1, 20_2), die in einer ersten Richtung beabstandet zu der Primärwicklung (10) angeordnet sind, die jeweils induktiv mit der Primärwicklung (10) gekoppelt sind und die jeweils wenigstens zwei in Reihe geschaltete Wicklungsabschnitte (23_1, 23_2, 24_1, 24_2) aufweist,
**dadurch gekennzeichnet, dass**
die wenigstens zwei Wicklungsabschnitte (23_1, 23_2, 24_1, 24_2) jeder der ersten und zweiten Sekundärwicklungen (20_1, 20_2) in wenigstens zwei unterschiedlichen Wicklungsebenen, angeordnet sind und
die Wicklungsabschnitte wenigstens einer Wicklungsebene an jeweils einem Ende eine zahnförmige Struktur mit Verbindungsanschlüssen (26_1, 26_2, 27_1, 27_2) aufweisen.

2. Signalübertrager nach Anspruch 1, bei dem die wenigstens zwei Wicklungsabschnitte (23_1, 23_2, 24_1, 24_2) einer Sekundärwicklung (20_1, 20_2) in einer zweiten Richtung versetzt zueinander in den wenigstens zwei Wicklungsebenen angeordnet sind.

3. Signalübertrager nach Anspruch 2, bei dem
jede der ersten und zweiten Sekundärwicklungen (20_1, 20_2) einen ersten Wicklungsabschnitt (23_1, 23_2) aufweist, der in der ersten Richtung beabstandet zu der Primärwicklung (10) in einer ersten Wicklungsebene angeordnet ist, und
jede der ersten und zweiten Sekundärwicklungen (20_1, 20_2) einen zweiten Wicklungsabschnitt (24_1, 24_2) aufweist, der in der ersten Richtung beabstandet zu den ersten Wicklungsabschnitten (23_1, 23_2) in einer zweiten Wicklungsebene angeordnet ist.

4. Signalübertrager nach Anspruch 3, bei dem
jede der ersten und zweiten Sekundärwicklungen (20_1, 20_2) wenigstens einen weiteren Wicklungsabschnitt (25_1, 25_2) aufweist, der beabstandet zu der zweiten Wicklungsebene in wenigstens einer weiteren Wicklungsebene angeordnet ist.

5. Signalübertrager nach einem der vorangehenden Ansprüche, bei dem
ein erster Stapel von Wicklungsabschnitten vorhanden ist, der in der ersten Richtung ausgehend von der Primärwicklung (10) abwechselnd Wicklungsabschnitte der ersten und zweiten Sekundärwicklung (20_1, 20_2) aufweist, und
ein zweiter Stapel von Wicklungsabschnitten vorhanden ist, der in der ersten Richtung ausgehend von der Primärwicklung (10) abwechselnd Wicklungsabschnitte der zweiten und ersten Sekundärwicklung (20_1, 20_2) aufweist, wobei der zweite Stapel in der zweiten Richtung benachbart zu dem ersten Stapel angeordnet ist.

6. Signalübertrager nach einem der vorangehenden Ansprüche, bei dem, die Wicklungsabschnitte (23_1 - 24_2) als Kreisringsegmente ausgebildet sind.

7. Signalübertrager nach Anspruch 6, bei dem die Kreisringsegmente einer Wicklungsebene jeweils einen gleichen Winkelbereich überdecken.

8. Signalübertrager nach Anspruch 6 oder 7, bei dem die Kreisringsegmente einer Wicklungsebene jeweils eine gleiche Fläche aufweisen.

9. Signalübertrager nach einem der vorangehenden Ansprüche, bei dem bei Anlegen einer Spannung an die Primärwicklung Spannungen in den einzelnen Wicklungsabschnitten (23_1-24_2) einer Sekundärwicklung (20_1, 20_2) induziert werden und bei dem die Wicklungsabschnitte (23_1 - 24_2) der ersten und wenigstens einen zweiten Sekundärwicklung (20_1, 20_2) so verschaltet sind, dass sich die in den einzelnen Wicklungsabschnitten (23_1 - 24_2) einer Sekundärwicklung (20_1, 20_2) durch die Primärwicklung (10) induzierten Spannungen addieren.

10. Signalübertrager nach Anspruch 9, bei dem die Wicklungsabschnitte (23_1 - 24_2) der ersten und zweiten Sekundärwicklung (20_1, 20_2) so verschaltet sind, dass sich die in den einzelnen Wicklungsabschnitten (23_1, 24_1) der ersten Sekundärwicklung (20_1) durch die Primärwicklung (10) induzierten Spannungen in umgekehrter Reihenfolge addieren als die in den einzelnen Wicklungsabschnitten (23_2, 24_2) der zweiten Sekundärwicklung (20_2) durch die Primärwicklung (10) induzierten Spannungen.

11. Signalübertrager nach einem der vorangehenden Ansprüche, bei dem die ersten Wicklungsabschnitte (23_1, 23_2)
jeweils einen Bezugspotentialanschluss (28_1, 28_2) aufweisen und
jeweils einen Verbindungsanschluss (27_1, 27_2) aufweisen, über den die ersten Wicklungsabschnitte (23_1, 23_2) jeweils an die zweiten Wicklungsabschnitte (24_1, 24_2) angeschlossen sind.

12. Signalübertrager nach Anspruch 11, bei dem die ersten Wicklungsabschnitte (23_1, 23_2) im Bereich der Bezugspotentialanschlüsse (28_1, 28_2) einstückig miteinander verbunden sind.

13. Signalübertrager nach einem der vorangehenden Ansprüche, der ein Trägersubstrat (40) aufweist, auf dem die Wicklungsabschnitte (23_1 - 24_2) angeordnet sind.

14. Signalübertrager nach Anspruch 13, bei dem das Trägersubstrat (40) ein Halbleitersubstrat ist.

15. Signalübertrager nach Anspruch 13 oder 14, bei dem die Wicklungsabschnitte (23_1 - 24_2) parallel zu einer Oberfläche (41) des Trägersubstrates (40) angeordnet sind.

16. Signalübertrager nach einem der vorangehenden Ansprüche, bei dem jeweils eine Dielektrikumsschicht (51) zwischen Wicklungsebenen der Sekundärwicklungen (20_1, 20_2) angeordnet ist.

17. Signalübertrager nach einem der vorangehenden Ansprüche, bei dem die Wicklungsabschnitte (23_1 - 24_2) aus einem Metall bestehen.

18. Signalübertrager nach Anspruch 1
bei dem erste Wicklungsabschnitte (23_1, 23_2), die in einer ersten Wicklungsebene angeordnet sind; als Kreisringsegmente ausgebildet sind, die in der ersten Wicklungsebene benachbart zueinander angeordnet sind, und
bei dem zweite Wicklungsabschnitte (24_1, 24_2), die in einer zweiten Wicklungsebene angeordnet sind, jeweils wenigstens einen offenen Kreisring aufweisen, wobei die Kreisringe der zweiten Wicklungsabschnitte konzentrisch angeordnet sind.

19. Signalübertrager nach Anspruch 18, bei dem jeder zweite Wicklungsabschnitt (24_1, 24_2) wenigstens zwei offene Kreisringe aufweist, wobei die Kreisringe eines ersten (24_1) der Wicklungsabschnitte und eines zweiten (24_2) der Wicklungsabschnitte innerhalb der zweiten Wicklungsebene abwechselnd angeordnet sind.

20. Signalübertragungsvorrichtung, die aufweist:
- einen Signalübertrager (1) nach einem der Ansprüche 1 bis 19,
- eine Sendeschaltung (40), die an die Primärwicklung (10) des Signalübertragers (1) angeschlossen ist,
- eine Empfängerschaltung (50) mit einem Differenzverstärker (56), die an die Sekundärwicklungen (20_1, 20_2) des Signalübertragers (1) angeschlossen ist.

21. Signalübertragungsvorrichtung nach Anspruch 20,
bei der die Sendeschaltung (40) eine erste Treiberschaltung (41) aufweist, die, an einen ersten Anschluss (11) der Primärwicklung (10) angeschlossen ist und die dazu ausgebildet ist, an diesen ersten Anschluss (11) nach Maßgabe eines ersten Sendesignals (S1) ein erstes oder zweites Ansteuerpotential anzulegen und
bei der die Sendeschaltung (40) eine zweite Treiberschaltung (41) aufweist, die an einen zweiten Anschluss (12) der Primärwicklung (10) angeschlossen ist und die dazu ausgebildet ist, an diesen zweiten Anschluss (12) nach Maßgabe eines zweiten Sendesignals (S2) ein erstes oder zweites Ansteuerpotential anzulegen.

## Claims

1. Signal transmitter which has:
a primary winding (10),
a first and at least one second secondary winding (20_1, 20_2) which are arranged at a distance from the primary winding (10) in a first direction and are in each case inductively coupled to the primary winding (10), and each of which has at least two series-connected winding sections (23_1, 23_2, 24_1, 24_2),
**characterized in that**
the at least two winding sections (23_1, 23_2, 24_1, 24_2) of each of the first and second secondary windings (20_1, 20_2) are arranged in at least two different winding levels, and
the winding sections in at least one winding level have a toothed structure with connections (26_1, 26_2, 27_1, 27_2) at in each case one end.

2. Signal transmitter according to Claim 1, wherein the at least two winding sections (23_1, 23_2, 24_1, 24_2) of a secondary winding (20_1, 20_2) are arranged offset with respect to one another in a second direction in the at least two winding levels.

3. Signal transmitter according to Claim 2, wherein
each of the first and second secondary windings (20_1, 20_2) has a first winding section (23_1, 23_2) which is arranged at distance from the primary winding (10) in the first direction in a first winding level, and
each of the first and second secondary windings (20_1, 20_2) has a second winding section (24_1, 24_2) which is arranged at a distance from the first winding sections (23_1, 23_2) in the first direction in a second winding level.

4. Signal transmitter according to Claim 3, wherein
each of the first and second secondary windings (20_1, 20_2) has at least one further winding section (25_1, 25_2) which is arranged at a distance from the second winding level in at least one further winding level.

5. Signal transmitter according to one of the preceding claims, wherein
a first stack of winding sections is provided, which has winding sections of the first and second secondary windings (20_1, 20_2) alternately, starting from the primary winding (10), in the first direction, and
a second stack of winding sections is provided, which has winding sections of the second and first secondary windings (20_1, 20_2) alternately, starting from the primary winding (10), in the first direction, with the second stack being arranged adjacent to the first stack in the second direction.

6. Signal transmitter according to one of the preceding claims, wherein the winding sections (23_1 - 24_2) are in the form of annular segments.

7. Signal transmitter according to Claim 6, in which the annular segments of one winding level each cover the same angular range.

8. Signal transmitter according to Claim 6 or 7, wherein the annular segments in one winding level each have the same area.

9. Signal transmitter according to one of the preceding claims, wherein, when a voltage is applied to the primary winding, voltages are induced in the individual winding sections (23_1 - 24_2) of a secondary winding (20_1, 20_2), and within which the winding sections (23_1 - 24_2) of the first and at least one second secondary winding (20_1, 20_2) are connected such that the voltages induced by the primary winding (10) in the individual winding sections (23_1-24_2) of one secondary winding (20_1, 20_2) are added.

10. Signal transmitter according to Claim 9, wherein the winding sections (23_1 - 24_2) of the first and second secondary windings (20_1, 20_2) are connected such that the voltages induced in the individual winding sections (23_1, 24_1) of the first secondary winding (20_1) are added in the opposite sequence to the voltages which are induced in the individual winding sections (23_2, 24_2) of the second secondary winding (20_2) by the primary winding (10).

11. Signal transmitter according to one of the preceding claims, wherein the first winding sections (23_1, 23_2)
each have a reference-ground potential connection (28_1, 28_2), and
each have one connection (27_1, 27_2) via which the first winding sections (23_1, 23_2) are connected to the second winding sections (24_1, 24_2).

12. Signal transmitter according to Claim 11, wherein the first winding sections (23_1, 23_2) are integrally connected to one another in the area of the reference-ground potential connections (28_1, 28_2).

13. Signal transmitter according to one of the preceding claims, which has a mount substrate (40) on which the winding sections (23_1 - 24_2) are arranged.

14. Signal transmitter according to Claim 13, wherein the mount substrate (40) is a semiconductor substrate.

15. Signal transmitter according to Claim 13 or 14, wherein the winding sections (23_1 - 24_2) are arranged parallel to one surface (41) of the mount substrate (40).

16. Signal transmitter according to one of the preceding claims, wherein a dielectric layer (51) is arranged between each of the winding levels of the secondary windings (20_1, 20_2).

17. Signal transmitter according to one of the preceding claims, wherein the winding sections (23_1 - 24_2) are composed of a metal.

18. Signal transmitter according to Claim 1, wherein first winding sections (23_1, 23_2) which are arranged in a first winding level are in the form of annular segments which are arranged adjacent to one another in the first winding level, and
wherein second winding sections (24_1, 24_2) which are arranged in a second winding level each have at least one open circular ring, with the circular rings of the second winding sections being arranged concentrically.

19. Signal transmitter according to Claim 18, wherein every second winding section (24_1, 24_2) has at least two open circular rings, with the circular rings of a first (24_1) of the winding sections and of a second (24_2) of the winding sections being arranged alternately within the second winding level.

20. Signal transmission apparatus which has:
- a signal transmitter (1) according to one of Claims 1 to 19,
- a transmission circuit (40) which is connected to the primary winding (10) of the signal transmitter (1),
- a receiver circuit (50) which has a differential amplifier (56) and is connected to the secondary windings (20_1, 20_2) of the signal transmitter (1).

21. Signal transmission apparatus according to Claim 20,
wherein the transmission circuit (40) has a first driver circuit (41), which is connected to a first connection (11) of the primary winding (10) and is designed to apply a first or second drive potential to this first connection (11) on the basis of a first transmission signal (S1), and
wherein the transmission circuit (40) has a second driver circuit (41), which is connected to a second connection (12) of the primary winding (10) and is designed to apply a first or second drive potential to this second connection (12) on the basis of a second transmission signal (S2).

## Revendications

1. Transformateur de signaux qui a :
un enroulement (10) primaire,
un premier et au moins un deuxième enroulements (20_1, 20_2), secondaires, qui sont disposés à distance dans une première direction de l'enroulement (10) primaire et dont chacun a au moins deux tronçons (23_1, 23_2, 24_1, 24_2) d'enroulement montés en série,
**caractérisé en ce que**
les au moins deux tronçons (23_1, 23_2, 24_1, 24_2) d'enroulement de chacun des premier et deuxième enroulements (20_1, 2°_2) secondaires sont disposés dans au moins deux plans d'enroulement différents et
les tronçons d'enroulement d'au moins un plan d'enroulement ont, à respectivement une extrémité, une structure dentelée ayant des bornes (26_1, 26_2, 27_1, 27_2) de liaison.

2. Transformateur de signaux suivant la revendication 1, dans lequel
les au moins deux tronçons (23_1, 23_2, 24_1, 24_2) d'un enroulement (20_1, 2°_2) secondaire sont disposés dans les au moins deux plans d'enroulement en étant décalés l'un par rapport à l'autre dans une deuxième direction.

3. Transformateur de signaux suivant la revendication 2, dans lequel
chacun des premier et deuxième enroulements (20_1, 20_2) secondaires a un premier tronçon (23_1, 23_2) d'enroulement qui, dans une première direction, est disposé à distance de l'enroulement (10) primaire dans un premier plan d'enroulement et
chacun des premier et deuxième enroulements (20_1, 20_2) secondaires a un deuxième tronçon (24_1, 24_2) d'enroulement qui est, dans la première direction, à distance des premiers tronçons (23_1, 23_2) d'enroulement disposés dans un deuxième plan d'enroulement.

4. Transformateur de signaux suivant la revendication 3, dans lequel
chacun des premier et deuxième enroulements (20_1, 20_2) secondaire a au moins un autre tronçon (25_1, 25_2) d'enroulement, qui est, à distance du deuxième plan d'enroulement, disposé dans au moins un autre plan d'enroulement.

5. Transformateur de signaux suivant l'une des revendications précédentes, dans lequel
il y a une première pile de tronçons d'enroulement du premier et du deuxième enroulements (20_1, 20_2) secondaires, qui a des tronçons d'enroulement en alternance dans la première direction en partant de l'enroulement (10) primaire, et
il y a une deuxième pile de tronçons d'enroulement du deuxième et du premier enroulements (20_1, 20_2) secondaires, qui a des tronçons d'enroulement en alternance dans la première direction en partant de l'enroulement (10) primaire, la deuxième pile étant dans la deuxième direction voisine de la première pile.

6. Transformateur de signaux suivant l'une des revendications précédentes, dans lequel les tronçons (23_1 à 24_2) d'enroulement sont constitués sous la forme de segments d'anneaux de cercle.

7. Transformateur de signaux suivant la revendication 6, dans lequel les segments d'anneaux de cercle d'un plan d'enroulement recouvrent respectivement une même plage angulaire.

8. Transformateur de signaux suivant la revendication 6 ou 7, dans lequel les segments d'anneaux de cercle d'un plan d'enroulement ont respectivement une même surface.

9. Transformateur de signaux suivant l'une des revendications précédentes, dans lequel, si une tension est appliquée à l'enroulement primaire, des tensions sont induites dans les divers tronçons (23_1 à 24_2) d'un enroulement (20_1 à 20_2) secondaire et dans lequel les tronçons (23_1 à 24_2) du premier d'au moins un deuxième enroulement (20_1 à 20_2) secondaire sont câblés de manière à ce que les tensions induites par l'enroulement (10) primaire dans les divers tronçons (23_1 à 24_2) d'un enroulement (20_1 à 20_2) secondaire s'additionnent.

10. Transformateur de signaux suivant la revendication 9, dans lequel les tronçons (23_1 à 24_2) du premier et du deuxième enroulements (20_1 à 20_2) secondaires sont câblés de manière à ce que les tensions induites par l'enroulement (10) primaire dans les divers tronçons (23_1 à 24_1) du premier enroulement (20_1) secondaire s'additionnent en ordre inverse des tensions induites par l'enroulement (10) primaire dans les divers tronçons (23_2 à 24_2) du deuxième enroulement (20_2) secondaire.

11. Transformateur de signaux suivant l'une des revendications précédentes, dans lequel les premiers tronçons (23_1 à 23_2) d'enroulement ont respectivement une borne (28) de potentiel de référence et respectivement une borne (27_1 à 27_2) de liaison, par laquelle les premiers tronçons (23_1 à 23_2) d'enroulement sont connectés respectivement au deuxième tronçon (24_1 à 24_2) d'enroulement.

12. Transformateur de signaux suivant la revendication 11, dans lequel les premiers tronçons (23_1 à 23_2) d'enroulement sont reliés entre eux d'une seule pièce dans la région de la borne (28) de potentiel de référence.

13. Transformateur de signaux suivant l'une des revendications précédentes, qui a un substrat (40) de support sur lequel sont disposés les tronçons (23_1 à 24_2) d'enroulement.

14. Transformateur de signaux suivant la revendication 13, dans lequel le substrat (40) de support est un substrat semi-conducteur.

15. Transformateur de signaux suivant la revendication 13 ou 14, dans lequel les tronçons (23_1 à 24_2) d'enroulement sont disposés parallèlement à une surface (41) du substrat (40) de support.

16. Transformateur de signaux suivant l'une des revendications précédentes, dans lequel une couche (51) diélectrique est disposée entre des plans des enroulements (23_1 à 20_2) secondaires.

17. Transformateur de signaux suivant l'une des revendications précédentes, dans lequel les tronçons (20_1 à 24_2) d'enroulement sont en un métal.

18. Transformateur de signaux suivant la revendication 1,
dans lequel des tronçons (23_1 à 23_2) d'enroulement, qui sont disposés dans un premier plan d'enroulement, sont constitués sous la forme de segments annulaires circulaires, qui sont disposés en étant voisins les uns des autres dans le premier plan d'enroulement et
dans lequel des deuxièmes tronçons (24_1 à 24_2), qui sont disposés dans un deuxième plan d'enroulement, ont respectivement au moins un anneau de cercle ouvert, les anneaux de cercle des deuxièmes tronçons d'enroulement étant disposés concentriquement.

19. Transformateur de signaux suivant la revendication 18, dans lequel chaque deuxième tronçon (24_1 à 24_2) d'enroulement a au moins deux anneaux de cercle ouverts, les anneaux de cercle d'un premier (24_1) des tronçons d'enroulement et d'un deuxième (24_2) des tronçons d'enroulement sont disposés en alternance dans le deuxième plan d'enroulement.

20. Dispositif de transformation de signaux qui a :
- un transformateur (1) de signaux suivant l'une des revendications 1 à 19,
- un circuit (40) d'émission, qui est connecté à l'enroulement (10) primaire du transformateur (1) de signaux,
- un circuit (50) de réception ayant un amplificateur (56) différentiel, qui est connecté aux enroulements (20_1 à 20_2) secondaires du transformateur (1) de signaux.

21. Dispositif de transformation de signaux suivant la revendication 20,
dans lequel le circuit (40) d'émission a un premier circuit (41) d'attaque, qui est connecté à une première borne (11) de l'enroulement (10) primaire et qui est constitué pour appliquer à cette première borne (11), en fonction d'un premier signal (S1) d'émission, un premier ou un deuxième potentiel de commande et
dans lequel le circuit (40) d'émission a un deuxième circuit (41) d'attaque, qui est connecté à une deuxième borne (12) de l'enroulement (10) primaire et qui est constitué pour appliquer à cette deuxième borne (12), en fonction d'un deuxième signal (S2) d'émission, un premier ou un deuxième potentiel de commande.
